Europäisches Patentamt

European Patent Office

Office européen des brevets

(11) Veröffentlichungsnummer: **0 309 451**
**B1**

(12) **EUROPÄISCHE PATENTSCHRIFT**

(45) Veröffentlichungstag der Patentschrift: 30.01.91

(51) Int. Cl.⁵: **H 03 K 5/01, H 04 B 15/00**

(21) Anmeldenummer: **87902433.9**

(22) Anmeldetag: **09.05.87**

(86) Internationale Anmeldenummer:
**PCT/DE87/00216**

(87) Internationale Veröffentlichungsnummer:
**WO 87/07792 17.12.87 Gazette 87/28**

(54) SCHUTZVORRICHTUNG GEGEN STÖRSIGNALE.

(30) Priorität: **06.06.86 DE 3619098**

(43) Veröffentlichungstag der Anmeldung:
**05.04.89 Patentblatt 89/14**

(45) Bekanntmachung des Hinweises auf die
Patenterteilung:
**30.01.91 Patentblatt 91/05**

(84) Benannte Vertragsstaaten:
**DE FR GB**

(56) Entgegenhaltungen:
**DE-A-2 832 766**
**FR-A-2 389 286**
**GB-A-2 059 210**
**GB-A-2 118 394**
**US-A-4 339 669**

(73) Patentinhaber: **ROBERT BOSCH GMBH**
**Postfach 50**
**D-7000 Stuttgart 1 (DE)**

(72) Erfinder: **KOHL, Walter**
**Monropostr. 17**
**D-7120 Bietigheim (DE)**
Erfinder: **NAGEL, Karl**
**Grundstr. 24**
**D-7413 Gomaringen (DE)**

Courier Press, Leamington Spa, England.

**Beschreibung**

Die Erfindung geht aus von einer elektrischen Schaltung mit einer zur Verarbeitung von Signalen dienenden Schaltungsanordnung und einer dieser vorgeschalteten Schutzvorrichtung gegen Störsignale nach der Gattung des unabhängigen Anspruchs 1.

Aus der GB-A-2059210 ist ein Impulsübertragungs- und -wiederholungsstromkreis für Fernsehempfänger bekannt, der einen ersten und einen zweiten Transistor in Differenzverstärkerschaltung enthält. Die Basis des zweiten Transistors ist dabei an dessen Kollektor angeschlossen, so daß der zweite Transistor als Diode wirkt, wobei die Kathode der Diode an den Emitter des ersten Transistors angeschlossen und des weiteren über eine Konstantstromquelle mit Masse verbunden ist. Die Anode der Diode liegt an dem einen Belag einer Kapazität, die mit ihrem anderen Belag an Masse angeschlossen ist. Die Askopplung des Ausgangssignals geschieht mit Hilfe zweier weiterer, als Stromspiegel geschalteter Transistoren im Kollektorkreis des ersten und des zweiten Transistors der Differenzverstärkerschaltung, wobei in den Emitterkreisen der beiden weiteren Transistoren jeweils Emittervorwiderstände angeordnet sind. Die Ausgangsklemme dieses bekannten Stromkreises wird durch den Verbindungspunkt zwischen dem Emitter des im Kollektorkreis des zweiten Transistors liegenden weiteren Transistors und dem ihm vorgeschalteten Emittervorwiderstand gebildet.

Aus der DE-A-28 32 766 ist des weiteren eine elektrische Schaltung nach der Gattung des unabhängigen Anspruchs 1 bekannt. Bei ihr weist die Schutzvorrichtung eine Kapazität auf, durch die im wesentlichen die Zeitkonstante eines gegen höherfrequente Störsignale oder Störimpulse wirkenden Tiefpaßfilters bestimmt wird. Das Tiefpaßfilter besteht dabei im wesentlichen aus einem Transistor, der bei Auftreten eines Störimpulses über die Kapazität leitend geschaltet wird und die Störquelle damit niederohmig belastet. Niederfrequente Signale führen nicht zu einem Ansprechen des Transistors, so daß die Schutzvorrichtigung wie ein Tiefpaßfilter wirkt.

Bei dieser bekannten Schutzvorrichtung wird eine sehr große Kapazität benötigt, die es nicht ohne weiteres erlaubt. die Schutzvorrichtung monolithisch zu integrieren, denn die in integrierten Schaltungen mit vertretbarem Aufwand realisierbaren Kapazitäten liegen in der Größenordnung von 100 pF. Weiterhin können Ströme nur bis herab zur Größenordnung von 0,5 μA sinnvoll realisiert werden. Für noch kleinere Ströme ist die Grenze durch Sperrströme gesetzt, die insbesondere bei hohen Temperaturen stark ansteigen. Daher ist der Realisierung von integrierten Tiefpaßfiltern in monolithisch integrierter Technik eine praktikable Grenze gesetzt, ab der aus Aufwands- oder Kostengründen mit einer von außen an die integrierte restliche Schutzvorrichtung anzuschließenden großen Kapazität gearbeitet wird.

Der vorliegenden Erfindung liegt daher die Aufgabe zugrunde, eine elektrische Schaltung nach der Gattung des unabhängigen Anspruchs 1 mit einer Schutzvorrichtung gegen Störsignale zu finden, die mit vertretbarem Aufwand voll monolithisch integrierbar ist und dennoch eine hohe Filterwirkung gegen Störsignale aufweist.

Gelöst wird die Aufgabe durch die kennzeichnenden Merkmale des unabhängigen Anspruchs 1 Vorteile der Erfindung

Die erfindungsgemäße Schaltung mit den kennzeichnenden Merkmalen des unabhängigen Anspruchs 1 hat den besonderen Vorteil, einen besonders geringen Bauelementeaufwand zu erfordern. Damit ist die Integration besonders kostengünstig, da die integrierte Schutzvorrichtung besonders wenig Fläche benötigt. Weiterhin weist die Schutzvorrichtung eine besonders geringe Temperaturempfindlichkeit auf. Die monolithisch integrierte Ausführung liefert für den Emitterfolger und die Diode nahezu idealen Gleichlauf, so daß bei der Übertragung eines Gleichspannungspegels besonders geringe Fehler auftreten.

Weitere besondere Vorteile und Ausgestaltungen der erfindungsgemäßen Schaltung sind in den abhägigen Anspruchen angegeben und ergeben sich aus der Beschreibung der nachfolgenden Ausführungsbeispiele.

Zeichnung

Die Erfindung wird anhand von Ausführungsbeispielen in der folgenden Beschreibung mit Hilfe der Zeichnung näher erläutert.

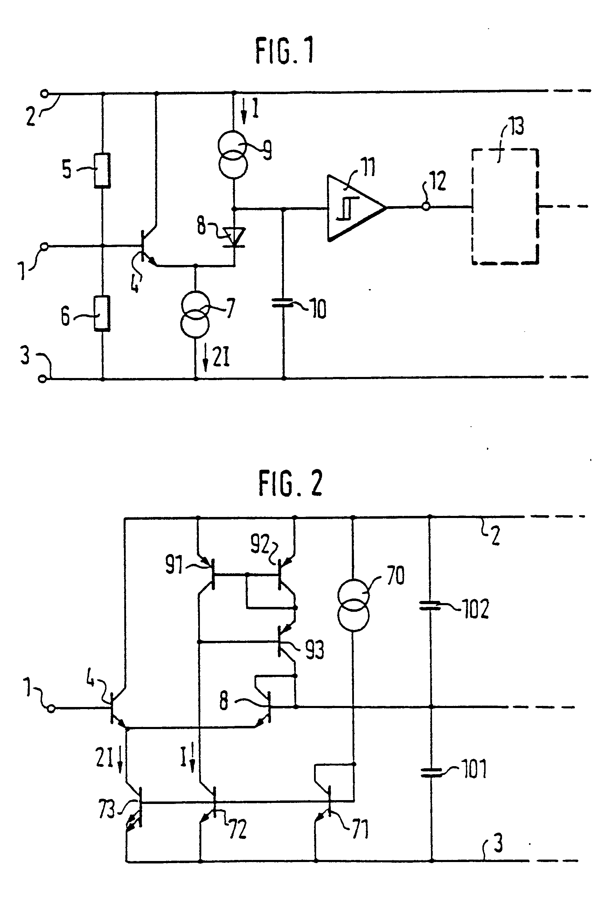

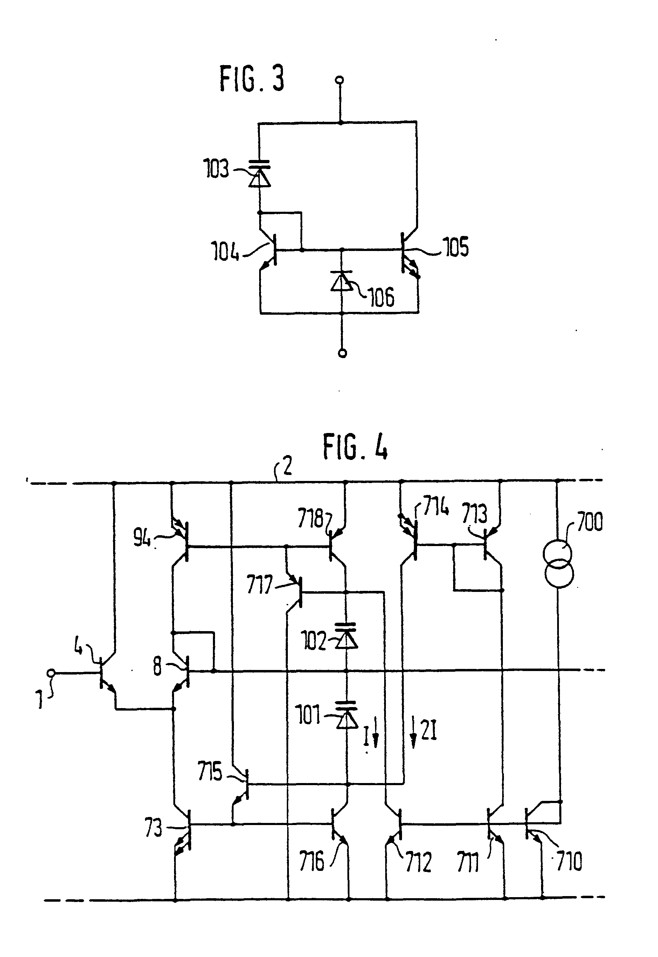

Figur 1 zeigt ein Prinzipschaltbild einer Schutzvorrichtung, die einem Eingang einer nachfolgenden Schaltungsanordnung vorgeschaltet ist; Figur 2 zeigt eine besonders einfache Ausführungsform, die für eine vollmonolithische Integration geeignet ist; Figur 3 zeigt eine Möglichkeit zur Vergrößerung der Kondensatorwirkung einer integrierten Sperrschichtkapazität; Figur 4 zeigt eine Ausführungsform mit besonders großer Kondensatorwirkung.

Beschreibung der Ausführungsbeispiele

In Figur 1 ist das Prinzipschaltbild einer möglichen erfindungsgemäßen Schaltung mit einem Signaleingang 1 dargestellt, die zwischen einer Versorgungsspannungsleitung 2 und einer Masseleitung 3 betrieben wird. Das an den Signaleingang 1 anzulegende Signal führt auf die Basis eines Transistors, der als Emitterfolger 4 wirkt. Ein Basisspannungsteiler aus zwei Widerständen 5, 6 ist weiterhin zwischen die Versorgungsspannungsleitung 2 und die Masseleitung 3 geschaltet. Der Emitter des Emitterfolgers 4 führt über eine Emitterstromquelle 7 zur Masseleitung 3. Weiterhin ist er mit der Kathode einer Diode 8 verbunden, deren Anode über eine Ladestromquelle 9 zur Versorgungsspannungsleitung 2 führt. Zwischen dem Verbindungspunkt der Diode 8 und der Ladestromquelle 9 ist eine Kapazität 10 gegen die Masseleitung 3 geschaltet. Der Verbindungspunkt ist weiterhin mit dem Eingang eines Schmitt-Triggers 11 verbunden, dessen Ausgang mit dem Eingang 12 einer aus Vereinfachungs-gründen nicht weiter dargestellten Schaltungsan-ordnung 13 verbunden ist.

Im Ruhezustand der Schutzvorrichtung, d.h., wenn kein Signal am Signaleingang 1 anliegt, ist das Potential an der Basis des Emitterfolgers 4 durch das Teilerverhältnis des Basisspannungsteilers 5, 6 und das Potential der Versorgungsspannung festgelegt. Da der Spannungsabfall an der Basis-Emitter-Diode des Emitterfolgers 4 durch den gleichgroßen Spannungsabfall an der Diode 8 kompensiert wird, liegt am Eingang des Schmitt-Triggers 11 im wesentlichen das gleiche Potential an, wie an der Basis des Emitterfolgers 4. Die Hysteresekennlinie des Schmitt-Triggers 11 ist so bemessen, daß im Ruhezustand am Eingang 12 ein eindeutiges Ruhepotential anliegt, das annähernd gleich dem an der Masseleitung anliegenden Potential ist.

Bei einem pötzlichen positiven Sprungsignal am Signaleingang 1 folgt das Potential am Emitter des Emitterfolgers 4 dem Sprungsignal entsprechend. Da das Potential an der Kapazität 10 und damit an der Anode der Diode 8 durch das vorherige Potential festgelegt ist, wird die Diode 8 gesperrt. Der Emitterfolger 4 übernimmt somit den gesamten Strom der Emitterstromquelle 7, während der gesamte Strom der Ladestromquelle 9 durch die Kapazität 10 integriert wird. Dies geschieht solange, bis die Spannung an der Kapazität 10 gleich dem Potential am Signaleingang 1 geworden ist.

Bei einem plötzlichen negativen Sprungsignal am Signaleingang 1 bleibt dagegen das Potential am Emitter des Emitterfolgers 4 bestehen, da es nicht unter die um die Durchflußspannung der Diode 8 verringerte Spannung an der Kapazität 10 sinken kann. Der den Emitter-folger 4 bildende Transistor wird also gesperrt. Der Kapazität 10 wird daraufhin durch die Stromquelle 7 über die Diode 8 solange Strom entzogen, bis das Potential am Eingang des Schmitt-Triggers 11 gleich dem Potential am Signaleingang 1 wird.

Bei einem rechteckförmigen Eingangssignal am Signaleingang 1 der Schutzvorrichtung nach Figur 1 entsteht also am Eingang des Schmitt-Triggers 11 ein entsprechendes trapezförmiges Signal. Die Flankensteilheiten des trapezförmigen Signals am Eingang des Schmitt-Triggers 11 sind durch die von der Emitterstromquelle 7 und der Ladestromquelle 9 gelieferten Ströme und die Größe der Kapazität 10 abhängig. Das trapezförmige Spannungssignal ist genau dann symmetrisch, wenn die Stromstärke des durch die Emitterstromquelle 7 fließenden Stroms genau doppelt so groß ist wie die Stromstärke des durch die Ladestromquelle 9 fließenden Stroms. Der Schmitt-Trigger 11 antwortet auf ein trapezförmiges Eingangssignal in bekannter Weise so, daß an seinem Ausgang ein gegenüber dem Eingangssignal verzögertes Rechtecksignal erscheint, das zur Ansteuerung der Schaltungsanordnung 13 herangezogen wird.

Die gesamte dargestellte Schutzvorrichtung wirkt also wie ein Tiefpaßfilter, das vor den Eingang 12 der Schaltungsanordnung 13 geschaltet ist. Es bietet daher einen besonders guten Schutz gegen impulsförmige Störsignale für die Schaltungsanordnung, wie sie beim Betrieb in einem Kraftfahrzeug häufig auftreten. Eine Anwendung der erfindungsgemäßen Schutzvorrichtung liegt daher hauptsächlich bei integrierten Reglern für Drehstromgeneratoren an Bord eines Kraftfahrzeugs. Die erfindungsgemäße Schutzvorrichtung ist aber universell einsetzbar und sowohl für analoge als auch digitale Nutzsignale geeignet.

Eine besonders für eine monolithische Integration geeignete einfache Schaltungsanordnung gemäß dem in Figur 1 dargestellten Prinzipschaltbild ist in Figur 2 gezeigt. Zur Vereinfachung der Darstellung ist gegenüber der Figur 1 kein Basisspannungsteiler und auch kein Schmitt-Trigger samt nachfolgender Schaltungsanordnung dargestellt.

Die in Figur 2 gezeigte Schutzvorrichtung weist einen Signaleingang 1 auf und wird zwischen einer Versorgungsspannungsleitung 2 und einer Masseleitung 3 betrieben. Das Eingangssignal führt wir in Figur 1 auf die Basis eines Transistors, der als Emitterfolger 4 wirkt. Die Diode 8 wird durch ein Transistor realisiert, dessen Kollektor und Basis miteinander kurzgeschlossen sind, um so die Anode der Diode 8 zu bilden. Die Kapazität 10 wird nun durch eine Kapazität 101 gebildet, die gegen die Masseleitung 3 geschaltet ist, und durch eine Kapazität 102 gebildet, die gegen die Versorgungsspannungsleitung 2 geschaltet ist. Die Gesamtkapazität setzt sich also additiv aus den Einzelkapazitäten 101, 102 zusammen.

Die Emitterstromquelle 7 und die Ladestromquelle 9 gemäß Figur 1 werden nun bei der in Figur 2 gezeigten Schutzvorrichtung aus einer einzigen Stromquelle 70 abgeleitet. Die Stromquelle 70 wird in einfachster Ausführungsform durch einen einzigen ohmschen Widerstand gebildet. Sie liefert einen Strom von der Versorgungsspannungsleitung 2 über einen als Eingangsdiode einer Stromspiegelanordnung geschalteten Transistor 71 zur Masseleitung 3. Die Stromspiegelanordnung besitzt zwei Ausgangstransistoren 72, 73. Der Strom durch den Kollektor des Ausgangstransistors 72 dient zur Ansteuerung der Ladestromquelle 9. Der Strom durch den Kollektor des Ausgangstransistors 73 stellt den Strom der Emitterstromquelle 7 dar, wozu der Kollektor des Ausgangstransistors 73 mit dem Emitter des Emitterfolgers 4 verbunden ist. Die Emitterflächen der Transistoren 71, 72, 73 sind so dimensioniert, daß der Ausgangsstrom durch den Transistor 73 doppelt so groß ist wie der Ausgangsstrom durch den Transistor 72.

Die Ladestromquelle 9 wird in bekannter Weise durch eine Stromquelle mit drei Transistoren 91, 92, 93 gebildet. Der Steuerstrom dieser Stromquelle wird, wie bereits gesagt, durch den Ausgangstransistor 72 bereitgestellt. Die Emitter der Transistoren 91, 92 sind mit der Versorgungsspannungsleitung 2 verbunden. Der Kollektor des Transistors 91 ist mit dem Kollektor des Transistors 72 und der Basis des Transistors 93 verbunden. Der Emitter des Transistors 93 ist mit dem Kollektor des Transistors 92 und den Basen der Transistoren 91, 92 verbunden. Der Kollektor des Transistors 93 wiederum führt auf die Anode der Diode 8.

Das Verhalten dieser in Figur 2 gezeigten Schaltungsanordnung entspricht dem der in Figur 1 gezeigten Prinzipanordnung, so daß aus Vereinfachungsgründen hier eine wiederholte Beschreibung unterbleiben kann.

Die Kapazität 10 bzw. die Kapazitäten 101, 102 können in integrierter Technik in beliebigen Varianten realisiert werden, beispielsweise in MOS-Technologie oder als Sperrschichtkapazitäten. Bei der Realisierung als Sperrschichtkapazitäten ist die Verwendung von zwei Kapazitäten gemäß der Anordnung nach Figur 2 besonders vorteilhaft, da die Sperrschichtkapazitäten von der angelegten Spannung abhängig sind. Dieser Effekt wird bei der Parallelschaltung zweier Kapazitäten 101, 102 kompensiert. Von besonderem Vorteil ist ebenfalls die Kompensation der gegenseitigen Sperrströme. Weiterhin werden Störungen auf der Versorgungsspannungsleitung 2 durch die kapazitive Spannungsteilung am Eingang des in Figur 1 dargestellten Schmitt-Triggers 11 nur verringert wirksam.

Eine Maßnahme zur Vergrößerung der Kondensatorwirkung einer Sperrschichtkapazität ist in Figur 3 dargestellt. Die Sperrschichtkapazität ist hierfür als in Sperrspannungsrichtung betriebene Kapazitätsdiode 103 dargestellt, die in Serie zur Emitter-Kollektor-Strecke eines als Eingangsdiode 104 eines Stromspiegels 104, 105 wirkenden Transistors geschaltet ist. Das Stromverhältnis des Stromspiegels 104, 105 wird durch die Emitterflächen einstellt. Wenn das Verhältnis der Fläche des Emitters der Eingangsdiode 104 zur Fläche des Emitters der Transistors 105 gleich 1/n gewählt ist, erscheint der in Figur 3 dargestellte Zweipol durch die Ladestromverstärkung als eine Sperrschichtkapazität mit der n+1-fachen Größe der Sperrschichtkapazität 103.

Zur Entladung der Sperrschichtkapazität 103 ist eine Diode 106 vorgesehen, die antiparallel zu den Basis-Emitter-Dioden des Stromspiegels 104, 105 geschaltet ist. Dabei erscheint die Sperrschichtkapazität 103 natürlich nicht um den Faktor n+1 verstärkt. Bei monolithischer Integration von Stromspiegeln mit npn-Transistoren kann die Diode 106 durch die Kollektor-Substrat-Diode der Eingangsdiode 104 gebildet werden.

Diese durch die Basis-Emitter-Spannungen des Stromspiegels oder der Diode verursachten Ansprechschwellen der Kapazitätsverstärkung können bei Verwendung der Schutzvorrichtung für analoge Nutzsignale zu einer Verfälschung des Ausgangssignals führen, was nicht erwünscht ist. Ein Ausführungsbeispiel der Erfindung, das diese nachteiligen Ansprechschwellen der Kapazitätsverstärkung nicht aufweist, ist in Figur 4 dargestellt.

Die in Figur 4 gezeigte Schutzvorrichtung ist wie bei den bisherigen Figuren 1 und 2 mit einem Signaleingang 1 versehen und wird zwischen einer Versorgungsspannungsleitung 2 und einer Masseleitung 3 betrieben. Das Eingangssignal wird in bereits beschriebener Weise auf einen Emitterfolger 4 geführt, dessen Emitter mit der Kathode einer Diode 8 verbunden ist. Die Anode der Diode 8 führt auf zwei Sperrschichtkapazitäten 101, 102 entsprechend der in Figur 2 gezeigten Darstellung.

Die Sperrschichtkapazität 101 führt von der Anode der Diode 8 über die Kollektor-Emitter-Strecke eines Transistors 716 zur Masseleitung 3. Die Basis des Transistors 716 ist mit der Basis eines Transistors 73 verbunden, dessen Kollektor-Emitter-Strecke vom Emitter des Emitterfolgers 4 zur Masseleitung 3 führt. Der Kollektor des Transistors 716 ist über die Basis-Emitter-Diode eines Transistors 715 mit der Basis des Transistors 73 verbunden. Der Kollektor des Transistors 715 ist dagegen an die Versorgungsspannungsleitung 2 angeschlossen. Die Transistoren 716, 73 bilden also einen Stromspiegel, wobei der Transistor 715 in bekannter Weise als Basisstromverstärker dient, um eine verbesserte Gleichlaufeigenschaft zwischen den Transistoren 716, 73 zu erreichen. In den Eingangsstrompfad des Stromspiegels 716, 73 ist die Sperrschichtkapazität 101 geschaltet, während der Ausgangsstrompfad mit dem Emitterfolger 4 bzw. der Diode 8 verbunden ist.

In hierzu vollkommen symmetrischer Weise wird die Sperrschichtkapazität 102 betrieben, die über die Kollektor-Emitter-Strecke eines Transistors 718 mit der Versorgungsspannungsleitung 2 verbunden ist. Als Stromverstärker dient ein Transistor 717, dessen Basis-Emitter-Diode parallel zur Kollektor-Basis-Strecke des Transistors 718 geschaltet ist und dessen Kollektor zur Masseleitung 3 führt. Durch einen Transistor 94 wird ein Stromspiegel 718, 94 gebildet, dessen Ausgangsstrompfad mit der Anode der Diode 8 verbunden ist.

Ein Vergleich der in den Figuren 4 und 1 gezeigten Darstellungen macht deutlich, daß der Transistor 94 in Figur 4 der Ladestromquelle 9 in Figur 1 entspricht, während der Transistor 73 in Figur 4 der Emitterstromquelle 7 in Figur 1 entspricht. Weiterhin ist in der Beschreibung zur in Figur 1 gezeigten Darstellung weiter oben ausgeführt, daß ein besonders symmetrisches Betriebsverhalten der erfindungsgemäßen Schutzvorrichtung damit erreicht wird, wenn die Stärke des von der Emitterstromquelle 7 gelieferten Stromes etwa doppelt so groß ist wie die Stromstärke des von der Ladestromquelle 9 gelieferten Stromes. Dieses Verhalten wird auch bei der in Figur 4 gezeigten Schutzvorrichtung eingestellt, indem dem der Transistor 718 mit einem Konstantstrom I beaufschlagt wird, während der Transistor 716 mit einem weiteren Konstantstrom 2I beaufschlagt wird, der die doppelte Stärke des ersten Konstantstromes I besitzt. Diese beiden Konstantströme I, 2I werden in bekannter Weise durch Kaskadierung mehrerer Stromspiegel aus einer einzigen Stromquelle 700 erzeugt. Die Stromquelle 700 kann in einfachster Ausführungsform durch einen einzigen ohmschen Widerstand realisiert werden. Der Strom der Stromquelle 700 fließt hierfür von der Versorgungsspannungsleitung 2 über einen als Eingangsdiode 710 einer Stromspiegelanordnung geschalteten Transistor zur Masseleitung 3. Die Stromspiegelanordnung besitzt zwei Ausgangstransistoren 711, 712, deren Emitter jeweils mit der Masseleitung 3 verbunden sind. Der Kollektor des Ausgangstransistors 712 ist mit der Basis des Basisstromverstärkers 717 verbunden. Der Kollektor des Ausgangstransistors 711 führt auf einen von der Versorgungsspannungsleitung 2 betriebenen Stromspiegel 713, 714, wobei der Transistor 713 als Eingangsdiode vom Kollektorstrom des Transistors 711 betrieben wird. Der Kollektor des Ausgangstransistors 714 führt auf den Basisstromverstärker 715. Die Emitterflächen des Stromspiegels 713, 714 und der Stromspiegelanordnung 710, 711, 712 sind so eingestellt, daß der Ausgangsstrom 2l des Transistors 714 genau doppelt so stark ist wie der Ausgangsstrom l des Transistors 712.

Bei der in Figur 4 gezeigten Darstellung erscheinen die Kapazitäten jeweils um das Übersetzungsverhältnis der Stromspiegel 718, 94 bzw. 716, 73 verstärkt. Die in Figur 4 gezeigte Anordnung ist ständig von Strom durchflossen Potentialänderungen an der Anode der Diode 8 führen über die geladenen Sperrschichtkapazitäten 101, 102 direkt zu einer zusätzlichen Ansteuerung der Stromspiegel. Da dies an einem Schaltungsknoten durch Stromaddition sowohl bei potentialanstieg als auch Potentialabfall an der Anode der Diode 8 geschieht, weist die Anordnung in Figur 4 nicht die bezüglich der Figur 3 geschilderten nachteiligen Ansprechschwellen für die Kapazitätsverstärkung auf.

## Patentansprüche

1. Elektrische Schaltung mit einer zur Verarbeitung von Signalen dienenden Schaltungsanordnung (13) und einer dieser vorgeschalteten Schutzvorrichtung gegen Störsignale mit einer Kapazität (10), durch die im wesentlichen die Zeitkonstante eines gegen Störsignale wirkenden Tiefpaßfilters bestimmt wird,
gekennzeichnet
durch einen Transistor (4), über den als Emitterfolger Nutzsignale und Störsignale in die Schutzvorrichtung eingekoppelt werden,
durch eine erste Stromquelle (7), die mit dem Emitter des Transistors (4) verbunden ist,
durch eine Diode (8), deren Kathode mit dem Emitter des Transistors (4) verbunden ist und
durch eine zweite Stromquelle (9), die mit der Anode der Diode (8) und mit einem der beiden Beläge der Kapazität (10) verbunden ist, wobei der andere Belag der Kapazität (10) an ein Bezugspotential gelegt ist, die Stärke des durch die erste Stromquelle (7) fließenden Stroms etwa doppelt so groß ist wie die Stärke des durch die zweite Stromquelle (9) fließenden Stroms und die Anode der Diode (8) den Ausgang der Schutzvorrichtung bildet.

2. Schaltung nach Anspruch 1, dadurch gekennzeichnet, daß die erste und die zweite Stromquelle (7, 9) durch Stromspiegelung aus einer gemeinsamen Stromquelle (70) gebildet werden.

3. Schaltung nach einem der vorhergehenden Ansprüche, dadurch gekennzeichnet, daß die Kapazität (10) aus einer ersten Kapazität (101), die gegen ein niederes Versorgungspotential (3) geschaltet ist, und einer zweiten Kapazität (102). die gegen ein hohes Versorgungspotential (2) geschaltet ist, gebildet wird.

4. Schaltung nach Anspruch 3, dadurch gekennzeichnet, daß die erste Kapazität (101) mit der Eingangsdiode (716) eines ersten Stromspiegels verbunden ist, dessen Ausgangstransistor (73) die erste Stromquelle (7) bildet, die mit einem ersten Konstantstrom (2l) beaufschlagt wird, und daß die zweite Kapazität (102) mit der Eingangsdiode (718) eines zweiten Stromspiegels verbunden ist, dessen Ausgangstransistor (94) die zweite Stromquelle (9) bildet, die mit einem zweiten Konstantstrom (l) beaufschlagt wird.

5. Schaltung nach Anspruch 4 dadurch gekennzeichnet, daß der erste Konstantstrom (2l) und der zweite Konstantstrom (l) durch Stromspiegelung aus einer gemeinsamen Stromquelle (700) gebildet werden.

6. Schaltung nach einem der vorhergehenden Ansprüche, dadurch gekennzeichnet, daß die Kapazität (10) durch Verstärkung des durch sie fließenden Stromes virtuell vergrößert wird.

7. Schaltung nach Anspruch 6, dadurch gekennzeichnet, daß eine Kapazität (103) in den Eingangsstrompfad eines Stromspiegels (104, 105) geschaltet ist, wobei eine Entladediode (106) antiparallel zur Eingangsdiode (104) des Stromspiegels (104, 105) geschaltet ist.

8. Schaltung nach Anspruch 7, dadurch gekennzeichnet, daß die Entladediode (106) durch die Kollektor-Substrat-Diode der Eingangsdiode (104) des Stromspiegels (104, 105) gebildet wird.

9. Schaltung nach einem der vorhergehenden Ansprüche, dadurch gekennzeichnet, daß die Diode (8) durch die Basis-Emitter-Diode eines Transistors gebildet wird.

10. Schaltung nach einem der vorhergehenden Ansprüche, dadurch gekennzeichnet, daß zwischen die Schutzvorrichtung und einen Eingang (12) der zur Verarbeitung von Signalen dienenden Schaltungsanordnung (13) hochohmige Verbindungsmittel, vorzugsweise ein Schmitt-Trigger (11), geschaltet sind und daß dem Transistor (4), über den als Emitterfolger Nutzsignale und Störsignale in die Schutzvorrichtung eingekoppelt werden, ein Basisspannungsteiler (5, 6) vorgeschaltet ist.

## Revendications

1. Circuit électrique avec un agencement de circuit (13) utilisé pour traiter des signaux et avec un dispositif de protection contre les signaux parasites branchés en amont de cet agencement de circuit, avec une capacité (10) grâce à laquelle la constante de temps d'un filtre passe-bas opposé à ces signaux parasites est essentiellement déterminée, circuit caractérisé en ce qu'il comporte:

un transistor (4), fonctionnant comme émetteursuiveur et par l'intermédiaire duquel des signaux utiles et des signaux parasites sont introduits dans le dispositif de protection,

une première source de courant (7) reliée à l'émetteur du transistor (4),

une diode (8) dont la cathode est reliée à l'émetteur du transistor (4),

une seconde source de courant (9) qui est reliée à l'anode de la diode (8) et avec une des deux armatures de la capacité (10), l'autre armature de cette capacité (10) étant mise à un potentiel de référence, l'intensité du courant circulant à travers la première source de courant (7) étant environ deux fois plus grande que l'intensité du courant circulant à travers la seconde source de courant (9), et l'anode de la diode (8) constituant la sortie du dispositif de protection.

2. Circuit selon la revendication 1, caractérisé en ce que la première et la seconde source de courant (7, 9) sont formées par réflexion de courant à partir d'une source de courant commune (70).

3. Circuit selon une des précédentes revendications caractérisé en ce que la capacité (10) est constituée par une première capacité (101) qui est branchée sur un potentiel d'alimentation réduit (3) et par une seconde capacité (102) qui est branchée sur un potentiel élevé d'alimentation (2).

4. Circuit selon la revendication 3, caractérisé en ce que la première capacité (101) est reliée à la diode d'entrée (716) d'un premier miroir de courant dont le transistor de sortie (73) constitue la première source de courant (7) qui est alimentée avec un premier courant constant (2I), tandis que la deuxième capacité (102) est reliée avec la diode d'entrée (718) d'un second miroir de courant, dont le transistor de sortie (94) constitue la seconde source de courant (9) qui est alimentée avec un second courant constant (I).

5. Circuit selon la revendication 4, caractérisé en ce que le premier courant constant (2I) et le second courant constant (I) sont formés par réflexion de courant à partir d'une source de courant commune (700).

6. Circuit selon une des précédentes revendications, caractérisé en ce que la capacité (10) est virtuellement augmentée par amplification du courant qui la traverse.

7. Circuit selon la revendication 6, caractérisé en ce qu'une capacité (103) est branchée sur le trajet de courant d'entrée d'un miroir de courant (104, 105), une diode de décharge (106) étant branchée en anti-parallèle sur la diode d'entrée (104) du miroir de courant (104, 105).

8. Circuit selon la revendication 7, caractérisé en ce que la diode de décharge (106) est formée par la diode collecteur-substrat de la diode d'entrée (104) du miroir de courant (104, 105).

9. Circuit selon une des précédentes revendications, caractérisé en ce que la diode (8) est formée par la diode base-émetteur d'un transistor.

10. Circuit selon une des précédentes revendications, caractérisé en ce qu'entre le dispositif de protection et une entrée (12) de l'agencement de circuit (13) servant au traitement de signaux, sont branchés des moyens de liaison de résistance ohmique élevée, de préférence une bascule de Schmitt (11), et qu'un diviseur de tension de base (5, 6) est branché en amont du transistor (4), fonctionnant en émetteursuiveur et par l'intermédiaire duquel des signaux utiles et des signaux parasites sont introduits dans le dispositif de protection.

## Claims

1. Electrical circuit having a circuit arrangement (13) serving to process signals, and, upstream thereof, a protective device against spurious signals having a capacitor (10), by means of which the time constant of a low-pass filter acting against spurious signals is essentially determined, characterized

by a transistor (4), via which as emitter follower useful signals and spurious signals are coupled into the protective device,

by a first current source (7), which is connected to the emitter of the transistor (4),

by a diode (8), whose cathode is connected to the emitter of the transistor (4), and

by a second current source (9), which is connected to the anode of the diode (8) and to one of the two foils of the capacitor (10), the other foil of the capacitor (10) being connected to a reference potential, the intensity of the current flowing through the first current source (7) being twice as high as the intensity of the current flowing through the second current source (9), and the anode of the diode (8) forming the output of the protective device.

2. Circuit according to Claim 1, characterized in that the first and the second current source (7, 9) are formed by current mirroring from a common current source (70).

3. Circuit according to one of the preceding claims, characterized in that the capacitor (10) is formed from a first capacitor (101) which is connected in opposition to allow supply potential (3), and by a second capacitor (102), which is connected in opposition to a high supply potential (2).

4. Circuit according to Claim 3, characterized in that the first capacitor (101) is connected to the input diode (716) of a first current mirror, whose output transistor (73) forms the first current source (7), to which a first constant current (2I) is applied, and in that the second capacitor (102) is connected to the input diode (718) of a second current source, whose output transistor (94) forms the second current source (9), to which a second constant current (I) is applied.

5. Circuit according to Claim 4, characterized in that the first constant current (2I) and the second constant current (I) are formed by current mirroring from a common current source (700).

6. Circuit according to one of the preceding claims, characterized in that the capacitor (10) is virtually increased by amplifying the current flowing through it.

7. Circuit according to Claim 6, characterized in that a capacitor (103) is connected to the input current path of a current mirror (104, 105), a discharge diode (106) being connected antiparallel to the input diode (104) of the current mirror (104, 105).

8. Circuit according to Claim 7, characterized in that the discharge diode (106) is formed by the collector-substrate diode of the input diode (104) of the current mirror (104, 105).

9. Circuit according to one of the preceding claims, characterized in that the diode (8) is formed by the base emitter diode of a transistor.

10. Circuit according to one of the preceding claims, characterized in that high-resistance connecting means, preferably a Schmitt trigger (11), are connected between the protective device and an input (12) of the circuit arrangement (13) serving to process signals, and in that a base voltage divider (5, 6) is connected upstream of the transistor (4), via which as emitter follower useful signals and spurious signals are coupled into the protective device.

## FIG. 1

## FIG. 2

1

# FIG. 3

# FIG. 4